Europäisches Patentamt

European Patent Office

Office européen des brevets

(19)

(11) Numéro de publication : **0 118 346**
**B1**

(12) **FASCICULE DE BREVET EUROPÉEN**

(45) Date de publication du fascicule du brevet :
27.05.87

(51) Int. Cl.⁴ : **H 05 K  7/10**

(21) Numéro de dépôt : **84400298.0**

(22) Date de dépôt : **14.02.84**

(54) **Connecteur comprenant au moins un contact présentant un bras élastiquement déformable.**

(30) Priorité : **25.02.83 FR 8303131**

(43) Date de publication de la demande :
**12.09.84 Bulletin 84/37**

(45) Mention de la délivrance du brevet :
**27.05.87 Bulletin 87/22**

(84) Etats contractants désignés :
**BE DE GB IT NL SE**

(56) Documents cités :
**EP-A- 0 030 763**
**EP-A- 0 047 607**
**DE-A- 2 315 484**
**DE-A- 2 656 920**
**FR-A- 2 219 605**
**US-A- 4 341 433**

(73) Titulaire : **SOCAPEX**
**10 bis, quai Léon Blum**
**F-92153 Suresnes (FR)**

(72) Inventeur : **Bricaud, Hervé**
**THOMSON-CSF SCPI 173, bld Haussmann**
**F-75379 Paris Cedex 08 (FR)**
Inventeur : **l'Henaff, Patrick**
**THOMSON-CSF SCPI 173, bld Haussmann**
**F-75379 Paris Cedex 08 (FR)**

(74) Mandataire : **Brullé, Jean et al**
**Service Brevets Bendix 44, rue François 1er**
**F-75008 Paris (FR)**

EP 0 118 346 B1

Il est rappelé que : Dans un délai de neuf mois à compter de la date de publication de la mention de la délivrance du brevet européen toute personne peut faire opposition au brevet européen délivré. auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18. rue St-Denis, 75001 Paris, France

## Description

La présente invention a pour objet un connecteur comprenant au moins un contact présentant un bras élastiquement déformable exerçant une force d'appui opposée à la direction d'insertion d'un objet à insérer et convenant plus particulièrement au raccordement à un circuit imprimé dudit objet à insérer, ce dernier étant un substrat présentant des plots ou des doigts de contacts disposés à plat tels que les substrats céramiques des circuits hybrides et par extension les micro-boîtiers à connexions périmétriques, connus sous l'appellation anglaise de « chip carrier ». De tels contacts sont généralement dénommés « contacts à force d'insertion nulle » par opposition aux contacts glissants.

De tels connecteurs sont connus de l'art antérieur par exemple par la demande de brevet européen 34 081 déposée le 27 janvier 1981 par la demanderesse où le circuit à raccorder est maintenu en place par un profilé élastique qui appuie élastiquement sur un capot pivotant. La force de pression exercée sur le capot est suffisante pour vaincre l'élasticité des contacts.

Cependant, la réalisation des contacts proprement dit pose un certain nombre de problèmes. D'une part, ces connecteurs sont susceptibles de recevoir un nombre très élevé de contacts individuels dont le coût unitaire doit être aussi peu élevé que possible. D'autre part, la force exercée par les contacts doit être aussi uniforme que possible.

On connaît également, par la demande de brevet EP 47 607, un connecteur comprenant des contacts insérés longitudinalement et présentant un bras élastiquement déformable exerçant une force d'appui opposée à la direction d'insertion d'un substrat.

On connaît aussi, par le document DE 2 315 484, la manière de fixer un contact dans l'alvéole d'un bloc isolant grâce à la présence d'une languette élastique associée à une cavité de rétention.

On a proposé des contacts insérés par les faces latérales du connecteur et maintenus en place par surmoulage et enduction de colle, ce qui en rend la fabrication délicate et coûteuse. Ces contacts présentent en outre l'inconvénient de supporter intégralement le poids du circuit qui leur est raccordé, celui-ci se positionnant uniquement par appui sur des zones élastiques des contacts. Une telle structure a alors pour inconvénient que les forces d'appui des contacts individuels sur le circuit ne sont pas homogènes d'un contact à l'autre et d'un bord à l'autre du circuit. Ces forces dépendent à la fois de la position précise de l'extrémité du contact, difficile à assurer avec une grande précision étant donné le procédé de fabrication mis en œuvre, de l'épaisseur du substrat et de l'homogénéité de l'application de la force d'appui transmise au circuit à raccorder.

La présente invention a pour objet un connecteur du type précité comprenant au moins un contact et qui ne présente pas les inconvénients précités. Dans un connecteur selon l'invention, les contacts sont insérés longitudinalement et se bloquent automatiquement en position en fin d'insertion sans que le contact puisse être retiré en exerçant une force de traction. Aucun collage ni surmoulage ne s'avère donc nécessaire. D'autre part, la partie élastique du contact destinée à coopérer avec le circuit à raccorder dépasse d'une distance donnée du corps isolant qui sert alors de butée pour le substrat à connecter.

L'invention concerne ainsi un connecteur électrique comprenant un bloc isolant dans lequel est ménagée au moins une alvéole destinée à recevoir un contact devant assurer une liaison électrique avec un substrat, le contact étant inséré longitudinalement et sensiblement parallèlement à la direction d'insertion du substrat et exerçant sur ce substrat une force d'appui qui s'oppose à son insertion, le contact comportant :

un corps coopérant avec au moins un bord de l'alvéole de sorte qu'une fois le contact inséré, il présente un axe longitudinal sensiblement parallèle à la direction des génératrices de l'alvéole,

une borne de sortie disposée à l'extrémité du corps qui est opposé au substrat, cette borne dépassant de l'alvéole,

un premier prolongement du corps formant butée pour le contact sur le bloc isolant dans le sens de l'insertion du contact,

une languette élastique de rétention du contact dans l'alvéole,

une partie constituée par un second prolongement du corps, dépassant de l'alvéole du côté du substrat, et destinée à assurer la liaison électrique avec le substrat par déformation élastique, ladite alvéole débouchant à cet endroit sur une face plane formant butée pour le substrat,

caractérisé en ce que :

le corps a une section en forme de U constituée par un fond et deux ailes,

le premier prolongement relie le corps à la borne de sortie,

la languette élastique de rétention coopère avec une face d'arrêt d'une cavité de rétention disposée dans l'alvéole de manière à former butée dans le sens opposé à l'insertion du contact une fois celui-ci inséré,

le second prolongement étant opposé au premier par rapport au corps, et étant formé d'un bras ressort relié au corps et sensiblement parallèle à l'axe longitudinal du corps, ce bras ressort étant prolongé par un levier par lequel la liaison électrique avec le substrat est assurée, le bras ressort et le levier étant situés dans des plans sensiblement perpendiculaires entre eux.

Le contact est par conséquent positionné dans son alvéole d'une part grâce à la fonction de guidage du corps du contact par au moins un bord de l'alvéole, et d'autre part par les deux butées précitées.

La borne de sortie du contact comporte, au niveau de son raccordement avec le corps du contact, un repli constituant ledit prolongement formant butée. Cette disposition a pour avantage d'une part de faire jouer à la borne de contact une fonction supplémentaire de butée et d'autre part, de donner la possibilité d'écarter la borne de sortie de l'axe longitudinal du contact de manière à faciliter l'insertion du contact dans l'alvéole et à permettre que la borne de sortie du contact soit disposée à la distance désirée de l'alvéole. Par exemple, ledit repli peut comporter au moins deux branches, ce qui permet d'éloigner sensiblement la borne de sortie de l'alvéole.

Le bras élastiquement déformable peut comporter une crosse formant zone de contact électrique.

L'alvéole peut comporter une fente de guidage du bras élastiquement déformable qui permet le passage libre de celui-ci lors de son insertion et son guidage transversal. La fente peut comporter une zone formant butée de sécurité pour le bras élastiquement déformable. Cette disposition est particulièrement intéressante car elle évite la destruction du contact qui pourrait se produire si le bras élastiquement déformable était poussé accidentellement à l'intérieur de la fente alors que normalement, en position de travail, sa zone de contact doit affleurer la surface du corps isolant. La zone formant butée peut être constituée par exemple par un décrochement disposé sur une paroi transversale fermant ladite fente.

Le bras élastiquement déformable comporte un levier dépassant de l'alvéole et un bras ressort de direction sensiblement parallèle à l'axe longitudinal du corps du contact. Le levier peut être relié au bras ressort par une zone de pliage disposée à l'extrémité libre du bras ressort et sur un bord latéral de celui-ci. L'axe du bras ressort peut être selon un mode de réalisation particulièrement avantageux légèrement incliné latéralement par rapport à l'axe longitudinal du corps de telle sorte que le plan médian du levier passe sensiblement au milieu de la zone de raccordement du bras ressort au corps du contact. Dans ces conditions, la poutre formée par le bras ressort travaille dans des conditions mécaniques optimales.

Le levier peut former un angle obtus avec le bras ressort, de telle sorte que le dépassement maximal du levier à l'extérieur de l'alvéole soit obtenu à l'extrémité de celui-ci.

Le bras ressort peut être séparé du corps du contact par une fente. Cette disposition est particulièrement avantageuse en ce sens que la fente peut être utilisée pour recevoir une pointe de contact électrique d'un dispositif de test sans interaction aucune avec le bras ressort et la borne de sortie.

La languette élastique de rétention peut être orientée suivant la direction longitudinale du corps du contact. La cavité de rétention peut alors présenter un rebord longeant la languette élastique de rétention et coopérant avec une portion latérale du corps du contact de manière à assurer le guidage du corps du contact également à ce niveau.

Selon une variante particulièrement avantageuse, le connecteur présente un moyen élastique pour plaquer le corps du contact contre une paroi latérale de l'alvéole. Selon un mode préféré, le moyen élastique a pour effet de plaquer le corps du contact simultanément contre ladite paroi latérale et ledit rebord longeant la languette élastique, ce qui permet de rallonger la longueur de guidage sans augmenter la longueur du corps du contact.

Pour faciliter le guidage du contact lors de son insertion, le corps du contact présente en section la forme générale d'un U présentant un fond et deux ailes, au moins une des deux ailes étant guidée longitudinalement sur au moins une partie de sa longueur par au moins une paroi latérale de l'alvéole.

Le bras élastique peut présenter au moins une portion parallèle au fond du corps et s'étendant à partir du bord d'une aile du corps de contact, ce bord étant opposé au fond de celui-ci.

La languette élastique de rétention peut être disposée sur une des ailes du corps en U du contact. La borne de sortie peut être disposée à une extrémité d'une des ailes du corps en U du contact. Le bras élastique peut être disposé à une extrémité d'une des ailes du corps du contact. En particulier, la borne de sortie et le bras élastique sont situés sur deux ailes différentes. Au cas où le bras élastique comporte un levier et un bras ressort, il est particulièrement avantageux pour la facilité de fabrication du contact que le levier soit relié au bras ressort par une zone de pliage située sur le bord latéral de celui-ci opposé au fond du U.

D'autre part, on disposera préférentiellement la languette élastique de rétention sur la même aile que la borne de sortie sur laquelle seront ainsi concentrés coaxialement les deux effets de butée du contact inséré.

Le moyen élastique pour plaquer le corps du contact contre une paroi latérale de l'alvéole peut être une languette élastique de pression ménagée sur une aile du corps du contact, notamment l'aile du corps du contact opposé à celle qui porte la première languette élastique, ce qui permet d'absorber tous les jeux et de maintenir la première languette élastique dans la face d'arrêt de la cavité de rétention. La languette élastique de pression peut être disposée à une extrémité de ladite aile du corps du contact.

Le bloc isolant peut comporter au moins une rainure recevant le repli de la borne de sortie correspondante.

L'invention concerne également un connecteur comportant une pluralité de contacts disposés suivant au moins une rangée. Les contacts disposés sur la même rangée peuvent présenter des bornes de sortie où le repli est situé au plus près du corps du contact, alternant avec des bornes de sortie dont le repli présente au moins deux branches de telle sorte que les bornes de sortie correspondant à ladite rangée se trouvent elles-même disposées suivant deux rangées.

L'invention sera mieux comprise à la lecture de la description qui va suivre donnée à titre d'exemple non limitatif, en liaison avec les figures qui représentent :

les figures 1 et 2a, en perspective deux types déterminés de connecteurs auxquels s'appliquent tout particulièrement l'invention, et la figure 2b, une vue de dessus de la figure 2a, avec une variante d'exécution du ressort ;

les figures 3a à 3c, respectivement en perspective avant, en perspective arrière et en vue latérale, un mode de réalisation préféré d'un contact selon l'invention ;

les figures 4a à 4c, des variantes de bornes de sortie du contact représenté aux figures 3a à 3c ;

la figure 5, une variante des contacts représentés précédemment adaptés à un montage à plat du connecteur sur un circuit imprimé ;

la figure 6a une coupe en perspective d'un contact et d'une alvéole avant insertion du contact ;

la figure 6b, une vue de dessus d'un contact dans une alvéole ;

les figures 7a et 7b en coupe verticale une alvéole d'un connecteur selon l'invention respectivement avant et après insertion du contact et la figure 7c un détail en vue de dessus de la figure 7a ;

la figure 7d, une coupe d'une alvéole avec son contact après montage d'un substrat suivant une variante à une rangée du mode de réalisation de la figure 1 ;

les figures 8 à 11, quatre variantes d'un contact suivant l'invention ;

la figure 12a en perspective avec arrachement les contacts des figures 8 et 9 montés chacun dans une alvéole d'un connecteur selon l'invention ;

la figure 12b, une vue de dessous d'un connecteur suivant l'invention où les contacts sont montés suivant une rangée et illustrant la possibilité de disposer les bornes de sortie suivant une ou deux rangées ;

les figures 13 à 15, différentes variantes d'implantation possibles sur un circuit imprimé recevant un dispositif selon l'invention.

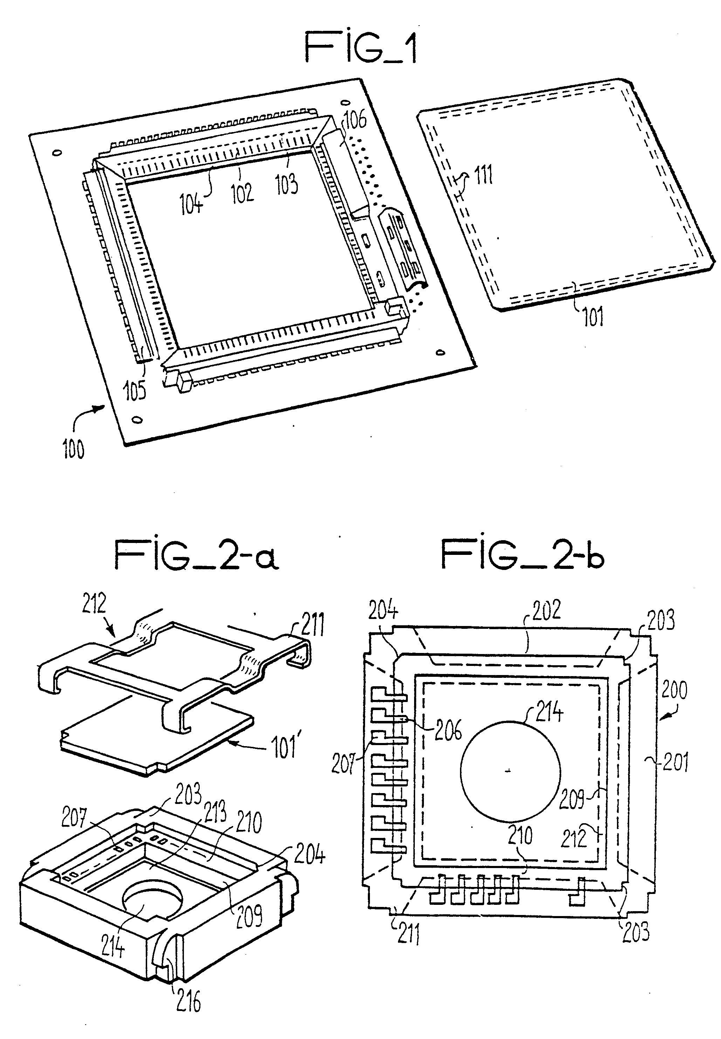

Selon la figure 1, le connecteur comporte quatre blocs isolants 104 portant des contacts dont les bornes de sortie sont brasées sur une plaque de circuit imprimé 100 de manière à assurer la continuité électrique. Chaque bloc isolant 104 présente deux rangées de contacts 102 et 103 présentant une déformabilité élastique exerçant une force d'appui opposée à la direction d'insertion d'un substrat. Les quatre blocs isolants 104 sont assemblés de manière à former un carré permettant de recevoir un substrat 101, par exemple un substrat céramique sur lequel sont reportés des circuits et portant à sa partie inférieure deux rangées de plots conducteurs 111. A la figure 1, le substrat 101 est représenté de telle sorte que sa face inférieure soit visible. Lorsque le substrat 101 est monté sur le connecteur 100, des volets 105 sont rabattus sur celui-ci et sont maintenus en place par des attaches 106 constituées par des profilés en U tels que décrits dans la demande de brevet européen N° 34 081. Le rabat 105 porte une protubérance 107 ayant fonction de butée pour absorber la composante horizontale de la force exercée par les attaches 106. Les parties élastiques des contacts 102 et 103 dépassent du bloc isolant d'une distance donnée, mais lorsque le substrat 101 est mis en place, il vient en butée contre une surface plane du bloc isolant ce qui définit précisément sa position géométrique et permet aux contacts d'exercer une force bien déterminée sur la métallisation correspondante. Cette disposition et plus particulièrement cette venue en butée du substrat 101 permet à chaque contact de se comporter comme s'il était seul. En outre, chacun des contacts est disposé dans une alvéole débouchant sur la partie supérieure du bloc isolant 104 ce qui permet d'utiliser la partie du contact disposée dans les alvéoles pour réaliser des tests ainsi qu'on le verra dans la suite de la description.

Selon les figures 2a et 2b, le connecteur 200 comporte un bloc isolant ici de forme générale carrée comportant à son pourtour une rangée au moins de contacts disposés dans des alvéoles 207 et dont chacun présente un bras élastique dépassant d'une rainure de guidage 206. Les extrémités des bras élastiques dépassent des rainures 206 au niveau d'un logement 210 destiné à recevoir un substrat 101' en général un micro-boîtier à connexion périmétrique. Le logement 210 présente des éléments de détrompage constitués ici de trois coins 203 formant un dièdre rentrant et d'un quatrième coin 204 biseauté. Le logement 210 est limité intérieurement par un décrochement 209 débouchant sur un fond 213 pourvu d'une ouverture 214 permettant un contact éventuel du substrat 101' et plus particulièrement des composants disposés sur celui-ci avec un drain thermique. Le fond du logement 210 est plat et sert de butée au substrat 101' qui est monté sur le connecteur. Comme dans la figure 1, les contacts individuels exercent sur les métallisations correspondantes du substrat 101' une force déterminée uniquement par la géométrie du contact et chaque contact se comporte comme s'il était seul. Le substrat 101' est maintenu en butée par un ressort 212 connu en soi et qui vient s'appliquer par dessus le substrat 101'. Le ressort 212 comporte des prolongements 211 qui permettent la fixation de celui-ci sur des rampes 216 disposées sur chacun des bords du bloc isolant 201.

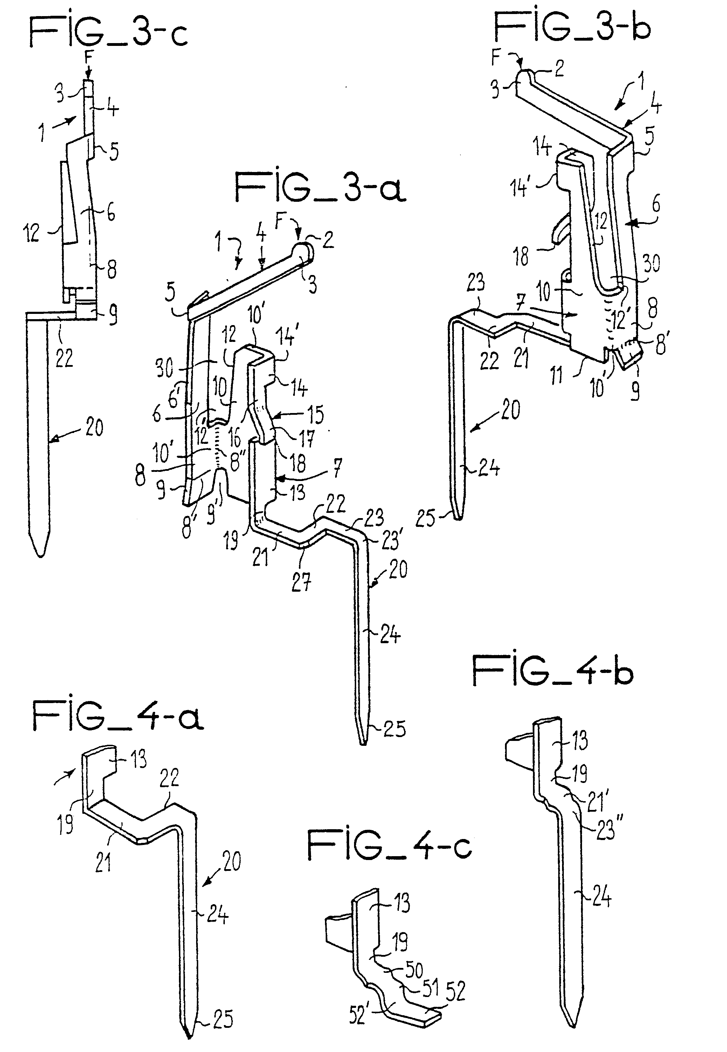

Selon les figures 3a à 3c, un contact électrique selon l'invention comporte un corps 7 en forme de U, dont l'axe longitudinal est représenté par convention vertical, et présentant un fond 10 et deux ailes, la première référencée 8 étant d'un seul tenant, et la seconde comprenant une partie inférieure 13 et une partie supérieure 14 situées dans le même plan et séparées par une languette élastique de rétention 15. La deuxième aile présente à l'extrémité de sa partie inférieure 13 une borne de sortie 20 comprenant successivement une zone de pliage 19, et trois branches horizontales respectivement 21, 22 et 23 dont la branche centrale 22 est orthogonale aux deux autres et dont la branche extrême 23 se prolonge par une patte de sortie 24 verticale à laquelle elle est reliée par une zone de pliage 23'. La patte 24 se termine par un biseau en V 25 facilitant son entrée dans les trous d'un circuit imprimé sur lequel la patte 24 est destinée a être soudée. La partie supérieure 14 de la deuxième aile se raccorde à la partie supérieure du fond 10 par une zone de pliage 14'. La partie supérieure 14 se prolonge vers le bas par la languette élastique 15. La languette élastique 15 présente une région élastique 16 formant ressort constituant le prolongement inférieur de la partie supérieure 14 de la deuxième aile, un bras incliné 17 formant un dièdre d'environ 150° avec la région élastique 16, et un pied 18 dirigé approximativement dans la direction verticale et qui assure le verrouillage proprement dit de la languette. Entre la languette 15 et le fond 10 subsiste une fente 18'.

L'aile 8 se prolonge à sa partie supérieure par un bras ressort vertical 6. A sa partie inférieure, elle est reliée à une languette de pression 9 par une zone de pliage 8' de telle sorte que la languette 9 s'étende vers l'extérieur de l'aile 8.

Le rebord latéral 6' du bras ressort 6 situé à l'opposé du fond du U 10 présente à son extrémité supérieure une zone de pliage 5 autour de laquelle est replié un levier 1 dont l'axe est incliné par rapport à l'horizontale (par exemple de l'ordre de 18°) de telle sorte que son extrémité 2 formant une crosse 3 soit située au-dessus de la partie supérieure 10' du corps 10 du contact. Le bras ressort 6 est séparé du corps 10 par une fente 30 bordée d'un côté par une paroi 12' du bras ressort 6 opposée à la paroi 6' et d'autre part, par une paroi 12 du corps du contact 10.

Le montage ainsi décrit du levier 1 par rapport au bras ressort 6 est particulièrement avantageux. Le levier 1 reçoit l'effort vertical d'application du substrat suivant la flèche F lors de l'insertion de celui-ci mais reste relativement rigide étant donné que cet effort est dirigé suivant la face latérale supérieure 4 du levier 1. D'autre part, étant donné que l'effort F est d'axe vertical, c'est-à-dire selon l'axe du bras ressort 6, celui-ci ne subit pas d'effort tranchant, mais seulement un moment fléchissant, autrement dit le bras ressort 6 fonctionne pratiquement en flexage pur, les efforts de compression longitudinale pouvant être négligés. Dans ce cas la forme idéale (poutre d'égale résistance) est un bras d'égale largeur et d'égale épaisseur ce qui permet de réaliser un bras ressort 6 de forme optimale par simple découpe dans l'aile 8 du U.

Le fonctionnement mécanique du bras support 6 est préférentiellement optimisé en inclinant l'axe de celui-ci par rapport à la verticale de telle sorte que le plan médian du levier 1 passe pratiquement au milieu du bras ressort 6 au pied de ce dernier. De ce fait, sous l'action de la force d'appui F, la partie supérieure 3 du contact se déplace sensiblement dans le plan vertical du levier 4 et les déformations secondaires tendant à l'écarter de ce plan, sous l'effet d'un couple de renversement perpendiculaire au plan du bras 6 sont négligeables et compatibles en pratique avec des jeux faibles entre le levier 1 et les bords d'une éventuelle fente de guidage 37. On remarquera en effet que tout flambage latéral du bras ressort 6 est répercuté de manière amplifiée par le bras de levier existant et peut être néfaste au bon alignement du contact s'il est trop important.

Il est également possible de donner facilement par découpe au levier 1 une forme permettant de le faire travailler en poutre d'égale résistance de manière à le faire participer à la flexion. Une telle poutre peut en effet être obtenue en faisant varier paraboliquement son épaisseur, cette épaisseur correspondant à la dimension du levier 1 prise dans la direction verticale. La réalisation en est donc possible par simple découpe.

La figure 4a, représente une variante des figures 3a à 3c dans laquelle on a supprimé la section 23 de la borne de sortie. Ceci permet de rapprocher le bras 24 du corps du contact avec une modification minimale de l'outillage de découpe, de manière à réaliser un contact d'écartement dit « moyen » par opposition avec le contact d'écartement dit « long » des figures 3a à 3c.

La figure 4b représente un contact d'écartement « court » c'est-à-dire où le bras 24 est situé pratiquement dans le prolongement de l'aile 13. Un rebord 21' obtenu par pliage en 19 et 23'' sert de butée au contact dans la direction de son insertion.

La figure 4c, est une variante du contact décrit aux figures 3a et 3c dans lequel la borne de sortie est adaptée à la brasure ou à la soudure à plat du connecteur ou a un contact par appui sur un circuit imprimé. A cet effet, il présente à partir de la zone de pliage 19 une courte section horizontale 50 formant butée, puis après pliage en 51' une courte section verticale 51 se prolongeant après pliage en 52' par une zone de contact proprement dite 52 horizontale formant un contact à plat.

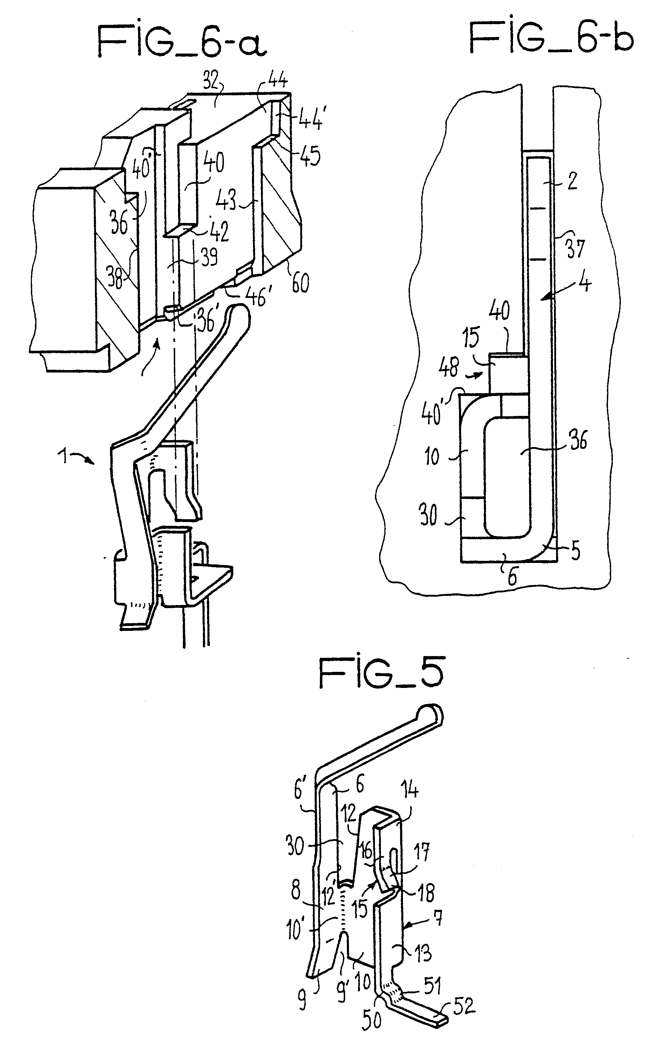

La figure 5 est une variante du contact précédent pour report à plat, illustrant une variante de la languette élastique se présentant sous la forme d'une simple lame 17' pliée en 16 vers l'extérieur de la branche 13 et dont l'extrémité 18' assure le verrouillage.

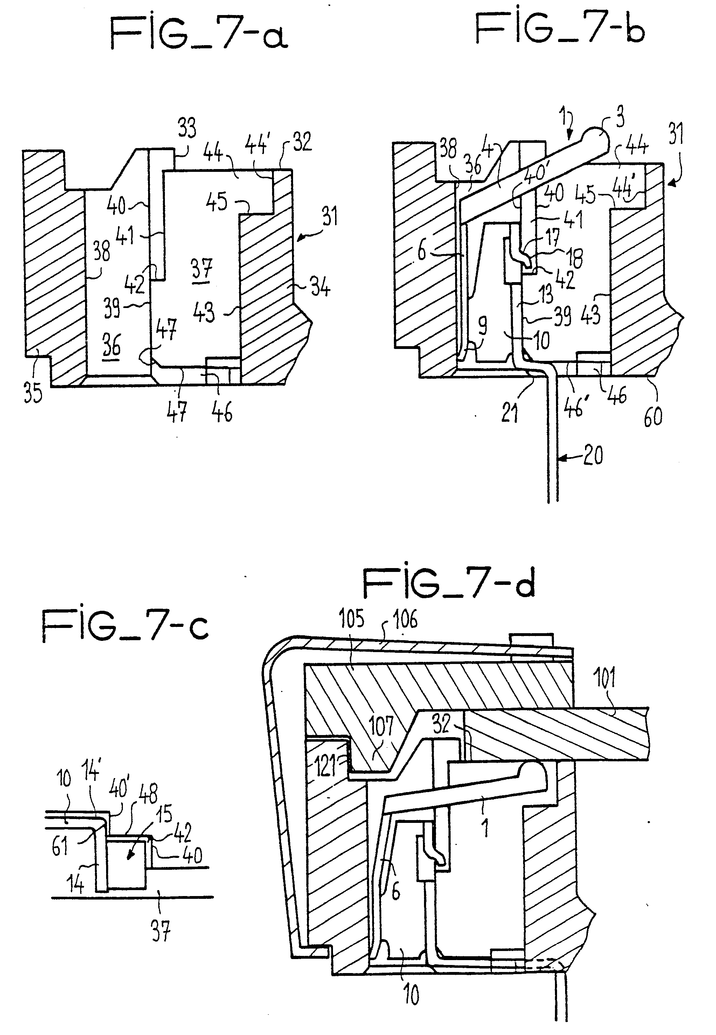

Selon les figures 6a, 7a, 7b et 7c l'alvéole 31 dans laquelle est disposé à titre illustratif un contact selon l'invention conforme à la figure 3a, pour la figure 6a et à la figure 4b pour la figure 7b comporte une cheminée 36 destinée à recevoir le corps 10 de contact dont les ailes 8 et 13 coulissent avec jeu le long des parois latérales respectivement 38 et 39. Des chanfreins d'entrée 36' sont prévus à la partie inférieure de la cheminée 36 pour faciliter l'insertion du contact. Lorsque le contact est en position inséré, le pied 18 de la languette élastique 17 est bloqué au jeu près contre la face d'appui 42 d'une cavité de rétention 41 délimitée par une paroi verticale 40 débouchant à la partie supérieure de l'alvéole ce qui permet éventuellement d'enlever le contact en introduisant un outil dans la cavité de rétention 41, cet outil venant porter sur la cambrure 17 de la languette élastique pour écarter de celle-ci de la face d'appui 42. D'autre part, la section 21 forme appui sur le fond 46' d'une rainure 46 ménagée à la partie inférieure 60 du bloc isolant 35. La languette élastique 9 vient porter contre la paroi 38 de la cheminée 36 de manière à plaquer l'aile 13 contre la paroi 39. Selon le perfectionnement représenté à la figure 7c, le guidage du corps du contact assuré par le plaquage par la languette 9 est prolongé à la partie supérieure de l'aile 13 grâce à un décrochement 48 délimitant une paroi verticale 40' prolongeant la paroi 39 et venant longer la partie supérieure 14 au débouché de la zone de pliage 14' au niveau de laquelle existe une zone plate 61 de largeur faible mais suffisante pour assurer la fonction de guidage. Dans ces conditions, le contact sera maintenu en place avec un débattement réduit au minimum.

Le levier 1 qui dépasse latéralement du corps 10 est guidé par une fente de guidage 37 limitée latéralement par une paroi 43 présentant à sa partie supérieure une cavité 44 bordée par une paroi verticale 44' et une paroi horizontale 45 formant butée de sécurité pour l'extrémité 3 du levier 1. Cette conception met à profit le fait que la déformée du bras ressort 6 en position travail est un arc de cercle (voir figure 7d), et donc que le déplacement de l'extrémité du levier 1 s'effectue en avançant vers l'intérieur de la cavité 44. Pendant l'insertion du contact dans l'alvéole, le levier 1 ne recevant pas de contrainte est en position d'extension maximale et longe la paroi 43.

Sur la figure 6b, on voit que vue de dessus, l'alvéole 36 laisse libre accès au corps 10 du contact. Cette propriété peut être mise à profit pour tester le contact sans influer sur l'action mécanique de celui-ci. A cet effet, une pointe de test est introduit dans la fente 30.

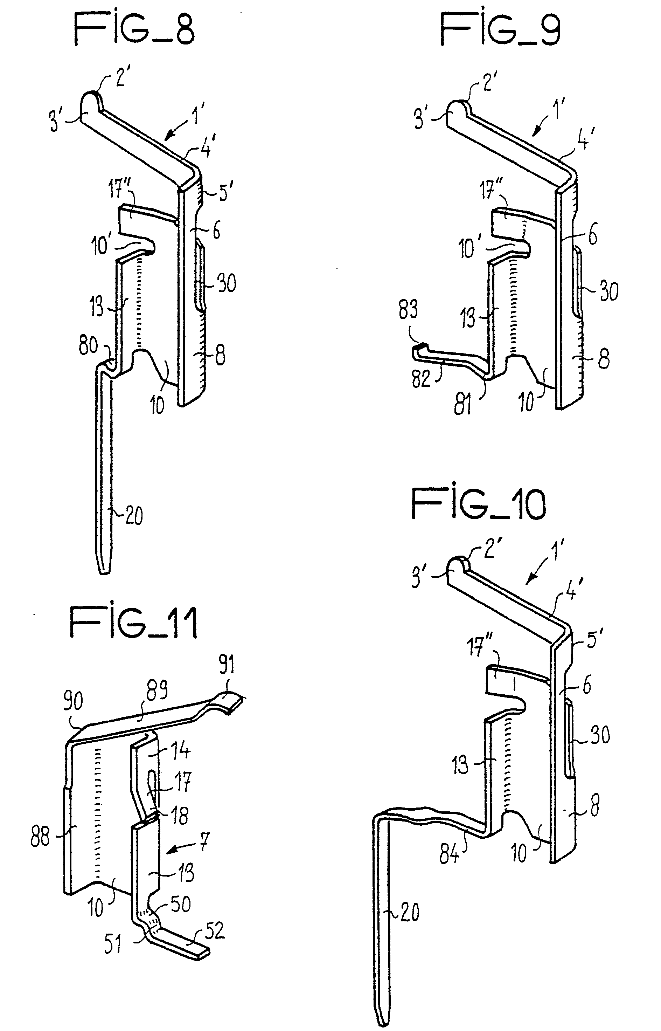

Les figures 8 à 10 représentent un autre mode de réalisation des contacts de l'invention, respectivement du type court, du type contact à plat et du type long. Ce mode de réalisation ne comporte pas de languette élastique 9, autrement dit, la tenue en place du contact est assurée uniquement par le jeu aussi faible que possible existant entre le corps du contact et l'alvéole. En particulier, on peut lors du cambrage des ailes du U laisser à celui-ci une certaine ouverture de manière à ce que les deux ailes du U soient maintenues en pression contre les parois de l'alvéole. En outre, une languette de rétention 17", visant à assurer la même fonction que les languettes 17 et 17' précédemment décrites, s'étend latéralement et est située dans le prolongement du fond 10 à sa partie supérieure. Enfin, un levier 1' analogue au levier 1 s'étend à partir du bord du bras ressort 6 qui jouxte le fond 10 du corps du contact, mais sa disposition est par ailleurs la même que pour le levier 1. Bien que ces variantes aient été représentées réunies, il va de soi qu'elles peuvent être mises en œuvre en combinaison ou séparément.

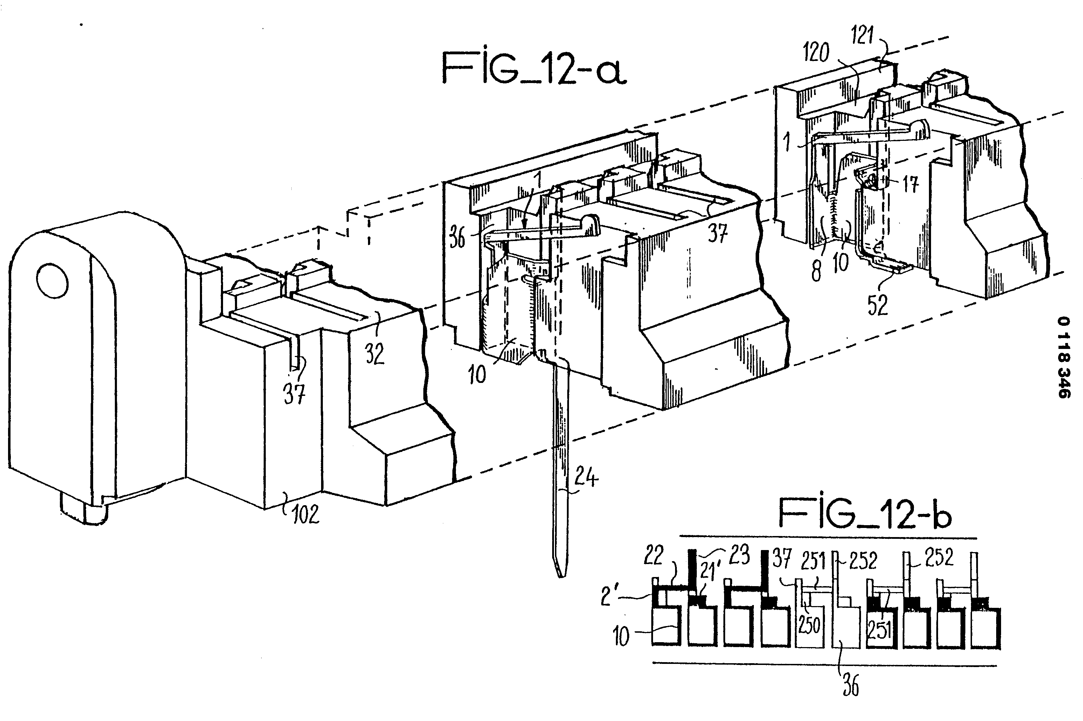

La figure 11 représente une variante du contact selon l'invention, dans laquelle le bras élastique consiste en une lame flexible 89 reliée à une aile 88 du corps 10 par un pliage 90.

Les contacts selon l'invention peuvent être réalisés par des opérations de découpage dans une bande et de pliage. La forme du contact décrit correspond à une bonne optimisation de la quantité de matière utilisée.

La figure 12a montre en perspective avec arrachement l'arrangement des contacts suivant une rangée dans un connecteur du type représenté à la figure 1. La même alvéole peut recevoir différents types de contacts, ici un contact court ou un contact à plat ce qui permet d'utiliser le même bloc isolant 102 dans différentes utilisations.

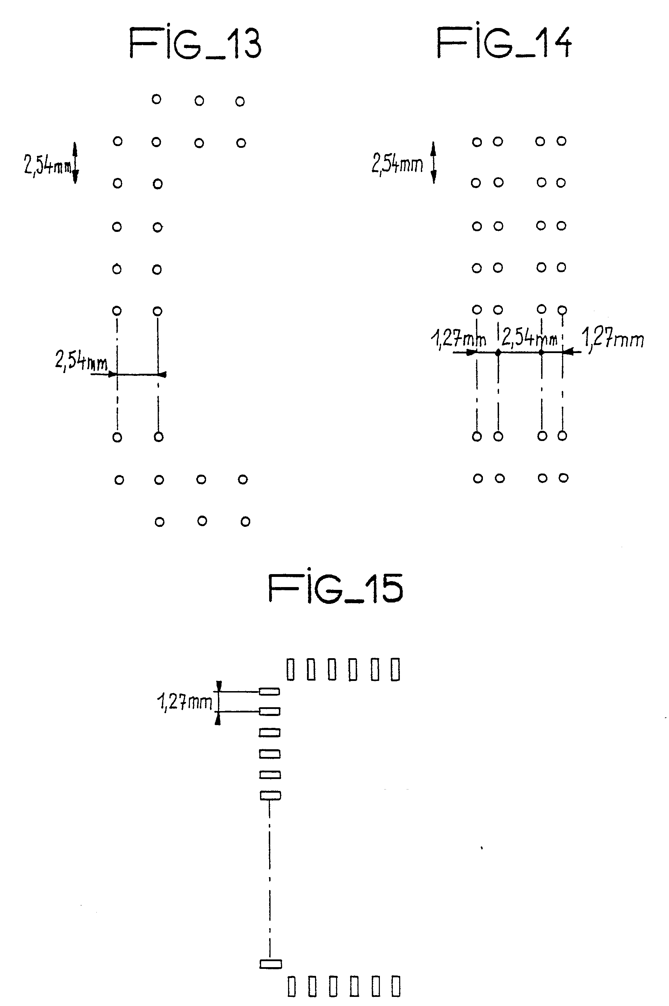

Selon la figure 12b, l'arrangement des contacts est suivant une rangée au niveau des bras élastiquement déformables, mais avec une disposition suivant deux rangées au niveau des bornes de sortie. Pour ce faire, les alvéoles 36 sont regroupées par groupes de deux. Pour chaque groupe de deux alvéoles, la face inférieure du bloc isolant 102 porte une rainure 251 disposée entre les fentes 37 des alvéoles correspondantes et qui est destinée au passage de la branche 22 d'un contact. D'autre part, une rainure 252 ménagée dans la face inférieure du bloc isolant est située dans le prolongement de la fente 37, d'une des alvéoles de chaque groupe de deux, de manière à recevoir la branche 23 d'un contact dit long. De cette manière, on peut faire alterner un contact court et un contact long (ou moyen) dans les alvéoles 36 de telle sorte que les bornes de sortie soient arrangées sur deux rangées de pas double de celui des contacts. L'implantation correspondante des trous métallisés sur le circuit imprimé est représentée à la figure 13 (pas de 2,54 mm correspondant à un pas de 1,27 mm en niveau du substrat 101).

Selon la figure 14, les contacts sont reportés suivant deux rangées au niveau des bras élastiquement déformables qui se divisent chacune en deux au niveau des bornes de sortie, ceci correspondant à un circuit imprimé présentant quatre rangées de trous arrangées suivant un pas de 2,54 mm, les deux rangées extrêmes étant séparées de la rangée adjacente par un intervalle de 1,27 mm et les deux rangées centrales par un pas de 2,54 mm. A cet effet les alvéoles reçoivent alternativement un contact court et un contact moyen.

La figure 15 illustre l'arrangement des plots conducteurs sur un circuit imprimé, correspondant à un bloc isolant portant des contacts pour brasure à plat ou contact par appui (figures 5 et 11).

L'invention ne se limite pas aux modes de réalisation décrits. Ainsi, des rangées de pas plus faible au niveau des bras élastiquement déformables peuvent être obtenues en disposant les alvéoles 36 tête-bêche et en interdigitant les rainures 37. Les alvéoles peuvent être ainsi disposées suivant deux rangées au pas de 1,27 mm encadrant une rangée centrale sur laquelle sont alignées avec un pas de 0,635 mm les rainures 37 interdigitées.

## Revendications

1. Connecteur électrique comprenant un bloc isolant (104) dans lequel est ménagée au moins une alvéole (36) destinée à recevoir un contact devant assurer une liaison électrique avec un substrat (101), le contact étant inséré longitudinalement et sensiblement parallèlement à la direction d'insertion du substrat et exerçant sur ce substrat une force d'appui qui s'oppose à son insertion, le contact comportant :

un corps (7) coopérant avec au moins un bord de l'alvéole (36) de sorte qu'une fois le contact inséré, il présente un axe longitudinal sensiblement parallèle à la direction des génératrices de l'alvéole,

une borne de sortie (20) disposée à l'extrémité du corps qui est opposée au substrat, cette borne dépassant de l'alvéole,

un premier prolongement (21) du corps formant butée pour le contact sur le bloc isolant (104) dans le sens de l'insertion du contact,

une languette élastique de rétention (15) du contact dans l'alvéole,

une partie constituée par un second prolongement du corps, dépassant de l'alvéole du côté du substrat, et destinée à assurer la liaison électrique avec le substrat par déformation élastique, ladite alvéole débouchant à cet endroit sur une face plane (32) formant butée pour le substrat, caractérisé en ce que :

le corps (7) a une section en forme de U constituée par un fond (10) et deux ailes,

le premier prolongement (21) relie le corps (7) à la borne de sortie (20),

la languette élastique de rétention (15) coopère avec une face d'arrêt d'une cavité de rétention disposée dans l'alvéole de manière à former butée dans le sens opposé à l'insertion du contact une fois celui-ci inséré,

le second prolongement étant opposé au premier par rapport au corps (7), et étant formé d'un bras ressort (6) relié au corps et sensiblement parallèle à l'axe longitudinal du corps, ce bras ressort étant prolongé par un levier (1) par lequel la liaison électrique avec le substrat est assurée, le bras ressort et le levier étant situés dans des plans sensiblement perpendiculaires entre eux.

2. Connecteur selon la revendication 1, caractérisé en ce que ledit premier prolongement du corps comporte au moins deux branches (21, 22, 23).

3. Connecteur selon l'une des revendications 1 ou 2, caractérisé en ce que l'extrémité (2) du second prolongement comporte une crosse (3) formant zone de contact électrique.

4. Connecteur selon une des revendications précédentes, caractérisé en ce que l'alvéole (36) comporte une fente (37) de guidage du second prolongement qui permet le passage libre de celui-ci lors de l'insertion du contact, ainsi que son guidage transversal.

5. Connecteur selon la revendication 4, caractérisé en ce que ladite fente (37) comporte une zone (45) formant butée de sécurité pour le second prolongement.

6. Connecteur selon la revendication 5, caractérisé en ce que la zone (45) formant butée est constituée par un décrochement (43) disposé sur une paroi transversale (44') fermant ladite fente.

7. Connecteur selon l'une quelconque des revendications 1 à 6, caractérisé en ce que le levier (1) est relié au bras ressort (6) par une zone de pliage (5) disposée à l'extrémité libre du bras ressort (6) et sur un bord latéral de celui-ci.

8. Connecteur selon l'une quelconque des revendications 1 à 7, caractérisé en ce que le levier (1) forme un angle obtus avec le bras ressort (6), de telle sorte que le dépassement maximal du levier à l'extérieur de l'alvéole (36) soit obtenu à l'extrémité (2) de celui-ci.

9. Connecteur selon l'une quelconque des revendications 1 à 8, caractérisé en ce que le bras ressort (6) est séparé du corps (7) du contact par une fente (30).

10. Connecteur selon l'une quelconque des revendications 1 à 9, caractérisé en ce que l'axe du bras ressort (6) est légèrement incliné latéralement par rapport à l'axe longitudinal du corps (7) du contact de telle sorte que le plan médian du levier (1) passe sensiblement au milieu de la zone de raccordement du bras ressort (6) au corps (7) de ce dernier.

11. Connecteur selon l'une quelconque des revendications précédentes, caractérisé en ce que la languette élastique de rétention (15) est orientée suivant la direction longitudinale du corps du contact.

12. Connecteur selon la revendication 11, caractérisé en ce que la cavité de rétention présente un rebord (40) longeant la languette élastique de rétention (15) et coopérant avec une portion latérale (14') du corps du contact (7) de manière à assurer le guidage du corps du contact également à ce niveau.

13. Connecteur selon une des revendications précédentes, caractérisé en ce qu'il présente un moyen élastique (9) pour plaquer le corps (17) du contact contre une paroi latérale (39) de l'alvéole.

14. Connecteur selon les revendications 12 et 13 prises ensemble, caractérisé en ce que le moyen élastique (9) est tel qu'il plaque le corps (7) du contact simultanément contre ladite paroi latérale (39) et ledit rebord (40') du corps du contact.

15. Connecteur selon l'une quelconque des revendications 1 à 14, caractérisé en ce que le second prolongement présente au moins une portion parallèle au fond (10) du corps (7) du contact et s'étendant à partir du bord (6') d'une aile (8) du corps (7) du contact, opposé au fond (10) de celui-ci.

16. Connecteur selon l'une des revendications 1 à 15, caractérisé en ce que la languette élastique de rétention (15) est disposée sur une des ailes (8, 13, 14) du corps en U du contact.

17. Connecteur selon l'une des revendications 1 à 16, caractérisé en ce que la borne de sortie (20) est disposée à une extrémité d'une des ailes (8, 13, 14).

18. Connecteur selon l'une des revendications 1 à 17, caractérisé en ce que le second prolongement est disposé à une extrémité d'une des ailes et dans le prolongement de celle-ci.

19. Connecteur selon les revendications 17 et 18 prises ensemble, caractérisé en ce que la borne de sortie (20) et le second prolongement sont situés sur deux ailes différentes (8, 13, 14).

20. Connecteur selon les revendications 16 à 19 prises ensemble, caractérisé en ce que la languette élastique de rétention (15) est disposée sur la même aile (13, 14) que la borne de sortie (20).

21. Connecteur selon la revendication 13 prise en combinaison avec une des revendications 15 à 20, caractérisé en ce que ledit moyen élastique est une languette élastique de pression (9) ménagée sur une aile (8) du corps du contact.

22. Connecteur selon les revendications 11 à 14 prises ensemble en combinaison avec une des revendications 15 à 20, caractérisé en ce que ledit moyen élastique est une deuxième languette élastique ménagée sur l'aile (8) du corps (7) du contact opposée à celle (13, 14) qui porte la première languette élastique (15).

23. Connecteur selon l'une des revendications 21 ou 22, caractérisé en ce que la languette élastique de pression (9) est disposée à une extrémité de ladite aile du corps du contact.

24. Connecteur selon une des revendications 1 à 23, caractérisé en ce que le bloc isolant (104) comporte au moins une rainure (251) recevant ledit repli de la borne de sortie correspondante.

25. Connecteur selon une des revendications précédentes, caractérisé en ce qu'il comporte une pluralité de contacts disposés suivant au moins une rangée, et en ce que les contacts disposés sur la même rangée présentent des bornes de sortie (20) dont le repli (50) est situé au plus près du corps du contact alternant avec des bornes de sortie (20) dont le repli présente au moins deux branches (21, 22) de telle sorte que les bornes de sortie correspondant à ladite rangée se trouvent elles-mêmes disposées suivant deux rangées.

**Claims**

1. Electrical connector comprising an isolating block (104) including at least one socket (36) intended to receive a contact for assuring an electrical connection with a substrate (101), the contact being inserted longitudinally and substantially parallel to the direction of insertion of the substrate and exerting upon said substrate an engagement force which opposes its insertion, the contact comprising :

a body (7) cooperating with at least one edge of the socket (36) such that, once the contact has been inserted, it presents a longitudinal axis substantially parallel to the direction of the generating lines of the socket,

an output terminal (20) disposed at the end of the body which is opposite to the substrate, said terminal extending beyond the socket,

a first extension (21) of the body forming an abutment for the contact on the isolating block (104) in the sense of insertion of the contact,

a resilient retention tongue (15) of the contact in the socket,

a portion constituted by a second extension of the body, extending beyond the socket on the side of the substrate and intended to assure the electrical connection with the substrate by resilient deformation, said socket opening thereat on a plane face (32) forming an abutment for the substrate, characterized in that :

the body (7) has a cross-section in the form of a U comprised of a bottom (10) and two legs,

the first extension (21) connects the body (7) to the output terminal (20),

the resilient retention tongue (15) cooperates with an abutment face of a retention cavity disposed in the socket such as to form an abutment in the sense opposite to the insertion of the contact once the latter has been inserted,

the second extension being opposite to the first one with respect to the body (7) and being formed by a spring arm (6) connected to the body and being substantially parallel to the longitudinal axis of the body, said spring arm being extended by a lever (1) assuring the electrical connection with the substrate, the spring arm and the lever being situated in planes that are substantially perpendicular to each other.

2. Connector according to claim 1, characterized in that said first extension of the body comprises at least two branches (21, 22, 23).

3. Connector according to any of claims 1 or 2, characterized in that the extremity (2) of the second extension comprises a head (3) forming an electrical contact zone.

4. Connector according to any of the preceding claims, characterized in that the socket (36) comprises a slot (37) for guiding the second extension which permits the free passages of the latter during insertion of the contact as well as its transverse guiding.

5. Connector according to claim 4, characterized in that said slot (37) comprises a zone (45) forming a security abutment for the second extension.

6. Connector according to claim 5, characterized in that the zone (45) forming an abutment is comprised of a recess (43) provided on a transverse wall (44') closing said slot.

7. Connector according to any of claims 1 to 6, characterized in that the lever (1) is connected to the spring arm (6) by a bending zone (5) disposed at the free end of the spring arm (6) and on a lateral edge of the latter.

8. Connector according to any of claims 1 to 7, characterized in that the lever (1) includes an obtuse angle with the spring arm (6) such that where the lever extends to the exterior of the socket (36) for a maximum distance occurs at the end (2) of the latter.

9. Connector according to any of claims 1 to 8, characterized in that the spring arm (6) is separated from the contact body (7) by a slot (30).

10. Connector according to any of claims 1 to 9, characterized in that the axis of the spring arm (6) is slightly inclined laterally with respect to the longitudinal axis of the contact body (7) such that the middle plane of the lever (1) passes substantially through the middle of the zone of connecting the spring arm (6) to the body (7) of the latter.

11. Connector according to any of the preceding claims, characterized in that the resilient retention tongue (15) is oriented in the longitudinal direction of the contact body.

12. Connector according to claim 11, characterized in that the retention cavity presents a projecting edge (40) extending along the resilient retention tongue (15) and cooperating with a lateral portion (14') of the contact body (7) such as to assure the guiding of the contact body at this level.

13. Connector according to any of the preceding claims, characterized in that it presents a resilient means (9) for urging the contact body (17) against a lateral wall (39) of the socket.

14. Connector according to claims 12 and 13 combined, characterized in that the resilient means (9) is such that it urges the contact body (7) simultaneously against said lateral wall (39) and said edge (40') of the contact body.

15. Connector according to any of claims 1 to 14, characterized in that the second extension presents at least one portion parallel to the bottom (10) of the contact body (7) and extending from the edge (6') of one leg (8) of the contact body (7) opposite to the bottom (10) of the latter.

16. Connector according to any of claims 1 to 15, characterized in that the resilient retention tongue (15) is disposed on one of the legs (8, 13, 14) of the U-shaped contact body.

17. Connector according to any of claims 1 to 16, characterized in that the output terminal (20) is disposed at one end of one of the legs (8, 13, 14).

18. Connector according to any of claims 1 to 17, characterized in that the second extension is disposed at one end of one of the legs and forms a prolongation of the latter.

19. Connector according to claims 17 and 18 combined, characterized in that the output terminal (20) and the second extension are situated on two different legs (8, 13, 14).

20. Connector according to claims 16 to 19 combined, characterized in that the resilient retention tongue (15) is disposed on the same leg (13, 14) as is the output terminal (20).

21. Connector according to claim 13 in combination with any of claims 15 to 20, characterized in that said resilient means is a resilient pressure tongue (19) formed on one leg (8) of the contact body.

22. Connector according to claims 11 to 14 combined in combination with any of claims 15 to 20, characterized in that said resilient means is a second resilient tongue provided on the leg (8) of the contact body (7) opposite to that (13, 14) which supports the first resilient tongue (15).

23. Connector according to any of claims 21 or 22, characterized in that the resilient pressure tongue (9) is disposed at an end of said leg of the contact body.

24. Connector according to any of claims 1 to 23, characterized in that the isolating block (104) comprises at least one groove (251) receiving said bend of the corresponding output terminal.

25. Connector according to any of the preceding claims, characterized in that it comprises a plurality of contacts disposed along at least one row, and in that the contacts disposed in the same row present output terminals (20), the bend (50) of which is situated closest to the contact body alternating with the output terminals (20) the bend of which presents at least two branches (21, 22) such that the corresponding output terminals in said range are themselves disposed along two rows.

**Patentansprüche**

1. Elektrischer Verbinder mit einem Isolierblock (104), in dem mindestens eine Buchse (36) zur Aufnahme eines Kontaktes gebildet ist, der zum Herstellen einer elektrischen Verbindung mit einem Substrat (100) dient, wobei der Kontakt in Längsrichtung und im wesentlichen parallel zu der Einsetzrichtung des Substrates eingesetzt ist und auf dieses Substrat eine Kraft ausübt, die dem Einsetzen des Substrates entgegenwirkt, wobei der Kontakt aufweist :

einen Körper (7), der mit mindestens einem Rand der Buchse (36) so zusammenwirkt, daß er, wenn der Kontakt einmal eingesetzt ist, eine Längsachse besitzt, die im wesentlichen parallel zur Richtung der Erzeugenden der Buchse verläuft,

eine Ausgangsklemme (20), die an dem dem Substrat entgegengesetzten Ende des Körpers angeordnet ist, wobei diese Klemme über die Buchse hinausragt,

eine erste Verlängerung (21) des Körpers, die einen Anschlag für den Kontakt am Isolierblock (104) in der Einsetzrichtung des Kontaktes bildet,

eine elastische Haltezunge des Kontaktes in der Buchse,

einen von einer zweiten Verlängerung des Körpers gebildeten Abschnitt, der über die Buchse auf der Seite des Substrates hinausragt und zum Herstellen der elektrischen Verbindung mit dem Substrat durch elastische Verformung dient, wobei die Buchse an dieser Stelle an einer ebenen Fläche (32) mündet, die einen Anschlag für das Substrat bildet, dadurch gekennzeichnet, daß :

der Körper (7) einen Querschnitt in Form eines U hat, das von einem Boden (10) und zwei Schenkeln gebildet wird,

die erste Verlängerung (21) den Körper (7) mit der Ausgangsklemme (20) verbindet,

die elastische Haltezunge (15) mit einer Anschlagfläche einer Halteausnehmung zusammenwirkt, die in der Buchse so angeordnet ist, daß sie einen Anschlag in der der Einsetzrichtung des Kontaktes entgegengesetzten Richtung bildet, wenn dieser einmal eingesetzt ist,

wobei die zweite Verlängerung der ersten bezüglich des Körpers (7) entgegengerichtet ist und von einem Federarm (6) gebildet wird, der mit dem Körper verbunden ist und im wesentlichen parallel zur Längsachse des Körpers verläuft, wobei dieser Federarm von einem Hebel (1) verlängert wird, durch den die elektrische Verbindung mit dem Substrat hergestellt wird, wobei der Federarm und der Hebel in im wesentlichen zueinander senkrechten Ebenen angeordnet sind.

2. Verbinder nach Anspruch 1, dadurch gekennzeichnet, daß die erste Verlängerung des Körpers mindestens zwei Zweige (21, 22, 23) aufweist.

3. Verbinder nach Anspruch 1 oder 2, dadurch gekennzeichnet, daß das Ende (2) der zweiten Verlängerung einen Kopf (3) aufweist, der eine elektrische Kontaktzone bildet.

4. Verbinder nach einem der vorhergehenden Ansprüche, dadurch gekennzeichnet, daß die Buchse (36) einen Schlitz (37) zur Führung der zweiten Verlängerung aufweist, welcher den freien Durchgang derselben beim Einsetzen des Kontaktes sowie ihre Führung in Querrichtung erlaubt.

5. Verbinder nach Anspruch 4, dadurch gekennzeichnet, daß der Schlitz (37) eine Zone (45) aufweist, die einem Sicherheitsanschlag für die zweite Verlängerung bildet.

6. Verbinder nach Anspruch 5, dadurch gekennzeichnet, daß die den Anschlag bildende Zone (45) von einem Rücksprung (43) an einer den Schlitz schließenden Querwand (44') gebildet wird.

7. Verbinder nach einem der Ansprüche 1 bis 6, dadurch gekennzeichnet, daß der Hebel (1) mit dem Federarm (6) durch einen Krümmungsbereich (5) verbunden ist, der am freien Ende des Federarmes (6) sowie an einem Seitenrand desselben angeordnet ist.

8. Verbinder nach einem der Ansprüche 1-7, dadurch gekennzeichnet, daß der Hebel (1) mit dem Federarm (6) einen stumpfen Winkel bildet, derart, daß sich die Stelle, an der der Hebel aus der Buchse (36) heraus maximal nach außen ragt, sich am Ende (2) der Buchse befindet.

9. Verbinder nach einem der Ansprüche 1-8, dadurch gekennzeichnet, daß der Federarm (6) von dem Kontaktkörper (7) durch einen Schlitz (30) getrennt ist.

10. Verbinder nach einem der Ansprüche 1-9, dadurch gekennzeichnet, daß die Achse des Federarmes (6) bezüglich der Längsachse des Kontaktkörpers (7) geringfügig seitlich geneigt ist, derart, daß die Mittelebene des Hebels (1) im wesentlichen durch die Mitte der Verbindungszone des Federarms (6) und des Körpers (7) desselben verläuft.

11. Verbinder nach einem der vorhergehenden Ansprüche, dadurch gekennzeichnet, daß die elastische Haltezunge (15) in Längsrichtung des Kontaktkörpers verläuft.

12. Verbinder nach Anspruch 11, dadurch gekennzeichnet, daß die Halteausnehmung einen vorstehenden Rand (40) aufweist, der entlang der elastischen Haltezunge (15) verläuft und mit einem seitlichen Abschnitt (14') des Kontaktkörpers (7) so zusammenwirkt, daß die Führung des Kontaktkörpers auf diesem Niveau sichergestellt wird.

13. Verbinder nach einem der vorhergehenden Ansprüche, dadurch gekennzeichnet, daß er ein elastisches Mittel (9) aufweist, um den Kontaktkörper (17) gegen eine Seitenwand (39) der Buchse anzudrücken.

14. Verbinder nach den Ansprüchen 12 und 13, dadurch gekennzeichnet, daß das elastische Mittel (9) so ausgebildet ist, daß es den Kontaktkörper (7) gleichzeitig gegen die Seitenwand (39) und den vorstehenden Rand (40') des Kontaktkörpers drückt.

15. Verbinder nach einem der Ansprüche 1-14, dadurch gekennzeichnet, daß die zweite Verlängerung mindestens einen Abschnitt aufweist, der parallel zum Boden (10) des Kontaktkörpers (7) verläuft und sich von einem dem Boden (10) desselben entgegengesetzten Rand (6') eines Schenkels (8) des Kontaktkörpers (7) erstreckt.

16. Verbinder nach einem der Ansprüche 1-15, dadurch gekennzeichnet, daß die elastische Haltezunge (15) auf einem der Schenkel (8, 13, 14) des U-förmigen Kontaktkörpers angeordnet ist.

17. Verbinder nach einem der Ansprüche 1-16, dadurch gekennzeichnet, daß die Ausgangsklemme (20) an einem Ende einer der Schenkel (8, 13, 14) angeordnet ist.

18. Verbinder nach einem der Ansprüche 1-17, dadurch gekennzeichnet, daß die zweite Verlängerung an einem Ende eines der Schenkel und in der Verlängerung desselben angeordnet ist.

19. Verbinder nach den Ansprüche 17 und 18, dadurch gekennzeichnet, daß die Ausgangsklemme (20) und die zweite Verlängerung an zwei verschiedenen Schenkeln (8, 13, 14) angeordnet sind.

20. Verbinder nach den Ansprüchen 16-19, dadurch gekennzeichnet, daß die elastische Haltezunge (15) an dem gleichen Schenkel (13, 14) wie die Ausgangsklemme (20) angeordnet ist.

21. Verbinder nach Anspruch 13 in Verbindung mit einem der Ansprüche 15-20, dadurch gekennzeichnet, daß das elastische Mittel eine elastische Druckzunge (9) ist, die an einem Schenkel (8) des Kontaktkörpers gebildet ist.

22. Verbinder nach den Ansprüchen 11-14 in Verbindung mit einem der Ansprüchen 15-20, dadurch gekennzeichnet, daß das elastische Mittel eine zweite elastische Zunge ist, die an dem Schenkel (8) des Kontaktkörpers (7) gebildet ist, der demjenigen (13, 14) gegenüberliegt, welcher die erste elastische Zunge (15) trägt.

23. Verbinder nach Anspruch 21 oder 22, dadurch gekennzeichnet, daß die elastische Druckzunge (9) an einem Ende des besagten Schenkels des Kontaktkörpers angeordnet ist.

24. Verbinder nach einem der Ansprüche 1-23, dadurch gekennzeichnet, daß der Isolierblock (104) mindestens eine Nut (251) aufweist, die die Krümmung der entsprechenden Auslaßklemme aufnimmt.

25. Verbinder nach einem der vorhergehenden Ansprüche, dadurch gekennzeichnet, daß er mehrere Kontakte aufweist, die in mindestens einer Reihe angeordnet sind, und daß die in der gleichen Reihe angeordneten Kontakte Ausgangsklemmen (20) aufweisen, deren Krümmung (50) dem Kontaktkörper am nächsten liegt, der sich mit den Ausgangsklemmen (20) abwechselt, deren Krümmung mindestens zwei Zweige (21, 22) aufweist, derart, daß die dieser Reihe entsprechenden Ausgangsklemmen ihrerseits in zwei Reihen liegen.

# FIG_1

# FIG_2-a

# FIG_2-b

FIG_3-c

FIG_3-a

FIG_3-b

FIG_4-a

FIG_4-c

FIG_4-b

0 1 1 8 3 4 6

FIG_6-a

FIG_6-b

FIG_5

3

# FIG_7-a

# FIG_7-b

# FIG_7-c

# FIG_7-d

# FIG_8

2'
3'
1'
4'
17''
5'
6
10'
30
13
80
8
10
20

# FIG_9

2'
3'
1'
4'
17''
10'
6
83
30
13
82
8
81
10

# FIG_10

2'
3'
1'
4'
17''
5'
6
13
30
8
84
10
20

# FIG_11

91
90
89
14
17
18
7
88
13
10
50
51
52

# FIG_12-a

120 121

1

17

36

37

1

8 10

52

10

37

32

24

102

# FIG_12-b

22   21'  23  37  251   252        252

2'

10   250   251   251

36

0 1 1 8 3 4 6

# FĪG_13

2,54mm

2,54mm

# FĪG_14

2,54mm

1,27mm  2,54mm  1,27mm

# FĪG_15

1,27mm